# EUROPEAN PATENT APPLICATION

(11) **EP 4 274 040 A1**
(43) Date of publication of application: **08.11.2023**
(21) Application number: 21913769.2
(22) Date of filing: 07.12.2021
(51) Int. Cl.: H01S 5/343, H01S 5/12

(54) **QUANTUM WELL STRUCTURE, CHIP PROCESSING METHOD, CHIP, AND LASER**

(30) Priority: 30.12.2020 CN 202011606707; 30.12.2020 CN 202023289626 U; 30.12.2020 CN 202011614713; 30.12.2020 CN 202023340352 U
(71) Applicant: Phograin Technology (Shenzhen) Co., Ltd., Shenzhen, Guangdong 518000 (CN)
(72) Inventor: YANG, Yanwei, Shenzhen, Guangdong 518000 (CN); LIU, Hongliang, Shenzhen, Guangdong 518000 (CN); ZOU, Yan, Shenzhen, Guangdong 518000 (CN)
(74) Representative: Taor, Simon Edward William
(86) International application number: PCT/CN2021/135908
(87) International publication number: WO 2022/143028

(57) **Abstract**

A quantum well structure, a method for processing a chip, a chip, and a laser are provided. The quantum well structure includes an indium aluminum arsenide (InAlAs) quantum well layer (231) and an indium aluminum gallium arsenide (InAlGaAs) quantum well layer (232). The InAlAs quantum well layer (231) is implemented as multiple InAlAs quantum well layers (231). The thickness of the InAlGaAs quantum well layer (232) is the same as the thickness of the InAlAs quantum well layer (231). The InAlGaAs quantum well layer (232) is disposed between two adjacent InAlAs quantum well layers (231). The thickness of the InAlAs quantum well layer (231) ranges from 0.4 nm to 0.6 nm. The number of the multiple InAlAs quantum well layers (231) ranges from 3 to 17. The thickness of the quantum well layer is small, such that under the condition that the thickness of the quantum well structure is constant, a ratio of the thickness of the quantum well structure to the thickness of the single-layer quantum well layer is increased, a value of quantum-well confinement parameter *Γ* is increased. With the increase of the quantum-well confinement parameter, the threshold current of the chip is reduced, thereby increasing the transmission rate of the chip.

## Description

### TECHNICAL FIELD

This disclosure relates to the field of laser technology, and in particular to a quantum well structure, a method for processing a chip, a chip, and a laser.

### BACKGROUND

Distributed feedback (DFB) laser chip structures mainly include N electrodes, multilayer quantum well epitaxial structures, Bragg grating layers, ridge waveguides, and P-type electrodes. Primarily, population reversion is formed by the multilayer quantum well structure under the action of a forward current, so as to form excited radiation and generate laser light.

The multilayer quantum well structure is the key to generate laser light. According to the principle of laser light, a threshold current of a laser chip is mainly related to a quantum-well confinement parameter. When the quantum-well confinement parameter is larger, the threshold current of the laser chip is smaller. However, according to an existing quantum well structure and a processing process, the confinement parameter is relatively small, the threshold current of the chip is relatively larger, and a transmission rate of the laser chip is seriously affected.

### SUMMARY

A series of simplified forms of concepts are introduced into the portion of Summary, which would be further illustrated in the portion of the detailed description. The Summary of the present disclosure does not mean attempting to define the key features and essential technical features of the claimed technical solution, let alone attempting to determine the protection scope thereof.

To solve a technical problem of a low transmission rate due to large threshold current of a chip, a main purpose of the present disclosure is to provide a quantum well structure, a method for processing a chip, a chip, and a laser.

To achieve the foregoing purpose of the present disclosure, following technical solutions are adopted in the present disclosure.

A quantum well structure for a distributed feedback (DFB) laser chip, includes an indium aluminum arsenide (InAlAs) quantum well layer and an indium aluminum gallium arsenide (InAlGaAs) quantum well layer. The InAlAs quantum well layer is implemented as multiple InAlAs quantum well layers. A thickness of the InAlGaAs quantum well layer is the same as a thickness of the InAlAs quantum well layer, and the InAlGaAs quantum well layer is disposed between two adjacent InAlAs quantum well layers. The thickness of the InAlAs quantum well layers ranges from 0.4 nm to 0.6 nm, and the number of the multiple InAlAs quantum well layers ranges from 3 to 17.

Further, in some implementations of the present disclosure, the thickness of the InAlAs quantum well layer is 0.5nm.

Further, in some implementations of the present disclosure, the number of the multiple InAlAs quantum well layers is 6, and the number of InAlGaAs quantum well layers is 5.

Further, in some implementations of the present disclosure, in the InAlGaAs quantum well layer, a mass percentage of indium (In) is 53%, a mass percentage of aluminum (Al) is 36%, and a mass percentage of gallium (Ga) and a mass percentage of arsenide (As) sum to 11%.

A method for processing a chip includes the following. A buffer layer and a lower-graded-layer group on a substrate are processed in sequence. Multiple quantum well layers are processed by a molecular beam epitaxy (MBE) process. A thickness of each of the multiple quantum well layers ranges from 0.4 nm to 0.6 nm. An upper-graded-layer group is processed. A capping layer, a corrosion stop layer, an epitaxial layer, and a contact epitaxial layer are processed by vapor phase epitaxy (VPE) growth.

Further, in some implementations of the present disclosure, processing the multiple quantum well layers by the MBE process includes the following. 11 quantum well layers are processed by the MBE process.

Further, in some implementations of the present disclosure, the thickness of each of the multiple quantum well layers is 0.5 nm.

Further, in some implementations of the present disclosure, processing the multiple quantum well layers by the MBE process includes the following. An InAlAs quantum well layer and an InAlGaAs quantum well layer are processed. The InAlAs quantum well layer is on an outside of the multiple quantum well layers.

A chip, processed by the foregoing method for processing the chip.

A laser, mounted with the foregoing chip.

A method for processing a chip includes the following. A chip-layer group is processed on a substrate. Part of the chip-layer group is removed to form a waveguide region. A capping layer is processed by growth. The capping layer at the waveguide region is processed into a waveguide strip with an end surface facing the chip-layer group. Part of the waveguide strip attached to the chip-layer group is removed to define a gap between the waveguide strip and the chip-layer group. A waveguide cladding is removed. The waveguide cladding corresponding to the chip-layer group and the waveguide cladding corresponding to the gap are removed.

Further, in some implementations of the present disclosure, removing the part of the chip-layer group to form the waveguide region includes the following. The part of the chip-layer group from one side of the substrate to the other side of the substrate is removed to form the waveguide region.

Further, in some implementations of the present disclosure, processing the capping layer by the growth includes the following. The capping layer of 0.5 µm to 2 µm is processed by VPE growth.

Further, in some implementations of the present disclosure, processing the capping layer at the waveguide region into the waveguide strip with the end surface facing the chip-layer group includes the following. The capping layer at the waveguide region is processed into the waveguide strip with a square cross section by a photoetching process and a dry etching process. An edge length of the cross section of the waveguide strip ranges from 0.5 µm to 2 µm.

Further, in some implementations of the present disclosure, processing the chip-layer group on the substrate includes the following. A buffer layer with a thickness of 1 µm-1.5 µm is processed on the substrate, a lower graded-buffer-layer with a thickness of 10 nm-100 nm is processed, a quantum-well-layer group with a thickness of 10 nm to 30 nm is processed, an upper graded-buffer-layer with a thickness of 10 nm-100 nm is processed, a grating epitaxial layer with a thickness of 10 nm-50 nm is processed, and a grating is processed by an electron beam grating-writing process, and a corrosion stop layer with a thickness of 10 nm-50 nm is processed in sequence.

Further, in some implementations of the present disclosure, the method further includes the following. After processing the waveguide cladding, an epitaxial layer and a contact epitaxial layer are processed in sequence, and the epitaxial layer at the waveguide region and the contact epitaxial layer at the waveguide region are removed.

A chip includes a substrate, a chip-layer group, a waveguide strip, and a waveguide cladding. The chip-layer group has a chip region and a waveguide region. The chip-layer group is disposed at the chip region of the substrate. The waveguide strip is spaced apart from the chip-layer group and integrated at the waveguide region of the substrate, and is configured to guide a light spot of laser light emitted to be substantially circular. The waveguide cladding is deposited on the waveguide strip.

Further, in some implementations of the present disclosure, a cross section of the waveguide strip is square, and an edge length of the cross section of the waveguide strip ranges from 0.5 µm to 2 µm. A thickness of the waveguide cladding ranges from 2 µm to 3 µm, and a refractive index of the waveguide strip is greater than a refractive index of the waveguide cladding.

Further, in some implementations of the present disclosure, a gap between the waveguide strip and the chip-layer group ranges from 1 µm to 5 µm.

A laser is mounted with the foregoing chip.

It can be seen from the foregoing technical solutions that advantages and positive effects of the quantum well structure, the method for processing the chip, the chip, and the laser in the present disclosure lie in that a quantum-well confinement parameter is increased, the threshold current of the chip is reduced, and the transmission rate of the chip is increased.

The quantum well structure is provided in a first aspect of the present disclosure. The quantum well structure includes the InAlAs quantum well layer and the InAlGaAs quantum well layer. The InAlAs quantum well layer is implemented as multiple InAlAs quantum well layers. The thickness of the InAlAs quantum well layer is the same as the thickness of the InAlGaAs quantum well layer. The InAlGaAs quantum well layers is disposed between the two adjacent InAlAs quantum well layers. The thickness of the InAlAs quantum well layer ranges from 0.4 nm to 0.6 nm, and the number of the multiple InAlAs quantum well layers ranges from 3 to 17.

Quantum-well confinement parameter *Γ* is expressed by a following formula: *Γ* = (2π²/*λ*²)(*d*/*dw*)(*nᵣₐ*²*-n_{rc}*²)*,* where *λ* is a lasing wavelength, and *d* is a thickness of an active region, i.e., a thickness of the whole quantum well structure, and *dw* is a thickness of a single-layer quantum well. In the solution of the present disclosure, the quantum well structure is formed by alternately stacking quantum well layers of two materials. The thickness of the InAlAs quantum well layer is the same as the thickness of the InAlGaAs quantum well layer. *dw* may be the thickness of the InAlAs quantum well layer or the thickness of the InAlGaAs quantum well layer, *nᵣₐ* is the refractive index of the InAlGaAs material, and *n_{rc}* is the refractive index of the InAlAs material. In the present disclosure, the thickness of InAlAs quantum well layer and the thickness of InAlGaAs quantum well layer each are small, and quantum-well confinement parameter *Γ* is increased, such that the threshold current of the chip is reduced, and the transmission rate of the chip is increased.

The method for processing the chip is provided in a second aspect of the present disclosure. The method includes the following. The buffer layer and the lower-graded-layer group are processed on the substrate in sequence. The multiple quantum well layers are processed by the MBE process. The thickness of each quantum well layer ranges from 0.4 nm to 0.6 nm. The upper-graded-layer group is processed. The capping layer, the corrosion stop layer, a top layer, a transition layer, and a contact layer are processed by the VPE growth. In the solution, a metal organic chemical vapor deposition (MOCVD) process is combined with the MBE process. The MBE process is adopted to perform epitaxial growth of the quantum well layer, and the MOCVD process is adopted to process various epitaxial growth layers except the quantum well layer. The thickness of the quantum well layer is controlled by the MBE process to range from 0.4 nm to 0.6 nm. With respect to an existing chip, the thickness of the quantum well structure is reduced, such that the transmission rate of the chip is increased; and in the meanwhile, quantum-well confinement parameter *Γ* is increased, such that the threshold current of the chip is reduced, and the transmission rate of the chip is increased.

A method for processing a chip in a third aspect of the present disclosure. The method includes the following. A chip-layer group is processed on a substrate. Part of the chip-layer group is removed to form a waveguide region. A capping layer is processed by growth. The capping layer at the waveguiding region is processed into a waveguide strip with an end surface facing the chip-layer group. Part of the waveguide strip attached to the chip-layer group is removed to define a gap between the waveguide strip and the chip-layer group. A waveguide cladding is processed. The waveguide cladding corresponding to the chip-layer group and the waveguide cladding corresponding to the gap are removed. The waveguide strip can shape laser light emitted by the chip-layer group, such that the light spot of the laser light emitted is like a circle, the shape of the light spot emitted by the laser chip is improved, and coupling efficiency between the laser chip and an optical fiber is improved.

A chip is provided in a fourth aspect of the present disclosure. The chip includes a substrate, a chip-layer group, a waveguide strip, and a waveguide cladding. The substrate has a chip region and a waveguide region. The chip-layer group is disposed at the chip region of the substrate. The waveguide strip is spaced apart from the chip-layer group and integrated at the waveguide region of the substrate. The waveguide strip is configured to guide a light spot of laser light emitted to be substantially circular. The waveguide cladding is deposited on the waveguide strip. Therefore, the shape of the light spot emitted by the chip is improved, the coupling efficiency between the laser chip and the optical fiber is improved, the threshold current of the chip is small, and the transmission rate is high.

A laser is provided in the present disclosure. The laser is mounted with the foregoing chip. The light spot of the laser light emitted guided by the waveguide strip of the chip is substantially circular, such that the shape of the laser light emitted is substantially the same as an shape of an end surface of the optical fiber, and the coupling efficiency between the laser and the optical fiber.

### BRIEF DESCRIPTION OF THE DRAWINGS

The accompanying drawings herein, which are incorporated into the specification and constitute a part of the specification, illustrate implementations consistent with the present disclosure and serve to explain the principles of the present disclosure together with the specification.

To explain technical solutions in implementations of the present disclosure or in the related art more clearly, the following will give a brief introduction to the accompanying drawings which are needed to be used in the description of implementations or the related art. Apparently, for those of ordinary skill in the art, other accompanying drawings can be obtained according to these accompanying drawings without creative efforts.
FIG. 1 is a flow chart of a method for processing a chip illustrated according to an exemplary implementation.
FIG. 2 is a schematic view of growing a capping layer by a method for processing a chip illustrated according to an exemplary implementation.
FIG. 3 is a schematic view of processing a capping layer by a method for processing a chip illustrated according to an exemplary implementation.
FIG. 4 is a schematic view of growing a waveguide cladding by a method for processing a chip illustrated according to an exemplary implementation.
FIG. 5 is a schematic view of processing a waveguide clipping by a method for processing a chip illustrated according to an exemplary implementation.
FIG. 6 is a schematic view of growing an epitaxial side and a contact epitaxial layer by a method for processing a chip illustrated according to an example implementation.
FIG 7 is a schematic view of processing an epitaxial side and a contact epitaxial layer by a method for processing a chip illustrated according to an exemplary implementation.
FIG 8 is a schematic structural view of a chip illustrated according to an exemplary implementation.
FIG 9 is a schematic view of a quantum well structure illustrated according to an exemplary implementation.

### Reference signs:

100-substrate; 200-chip-layer group; 300-waveguide strip; 400-capping layer; 500-waveguide cladding; 600-epitaxial layer; 700-contact epitaxial layer; 800-upper negative-electrode layer;900-lower negative-electrode layer; 210-buffer layer; 220-lower graded-buffer-layer; 230-quantum-well-layer group; 240-upper graded-buffer-layer; 250-grating layer; 260-corrosion stop layer; 221-second lower-graded-layer; 241-second upper-graded-layer; 231-indium aluminum arsenide (InAlAs) quantum well layer; 232-indium aluminum gallium arsenide (InAlGaAs) quantum well layer.

### DETAILED DESCRIPTION

In order to make a purpose, a technical solution, and an advantage of implementations of the present disclosure clearer, the technical solution of the implementations of the present disclosure will be described clearly and completely in conjunction with accompanying drawings in the implementations of the present disclosure. Obviously, described implementations are part of the implementations of the present disclosure, not all of the implementations. All other implementations obtained by those of ordinary skill in the art based on implementations of the present disclosure without creative efforts shall belong to the scope of protection of the present disclosure. Therefore, the following detailed description of the embodiments of the present disclosure provided in the accompanying drawings shall not be intended to limit the scope of protection of the present disclosure, but merely represent selected implementations of the present disclosure. All other implementations obtained by those of ordinary skill in the art based on implementations of the present disclosure without creative efforts shall belong to the scope of protection of the present disclosure.

A method for processing a chip, a chip, and a laser are provided in implementations. The chip is formed by the method for processing the chip. The laser is mounted with the chip. The method for processing the chip includes the following. A chip-layer group 200 is processed on the substrate 100. Part of the chip-layer group 200 is removed to form a waveguide region. A capping layer 400 is processed by growth. The capping layer 400 at the waveguide region is processed into a waveguide strip 300 with an end surface facing the chip-layer group 200. Part of the waveguide strip 300 facing the chip-layer group 200 is removed to define a gap between the waveguide strip 300 and the chip-layer group 200. A waveguide cladding 500 is processed, and the waveguide cladding 500 corresponding to the chip-layer group 200 and the waveguide cladding 500 corresponding to the gap are removed. The waveguide strip 300 can shape laser light emitted by the chip-layer group 200, such that a light spot of the laser emitted is like a circle.

In implementations, a method for processing a chip includes the following.

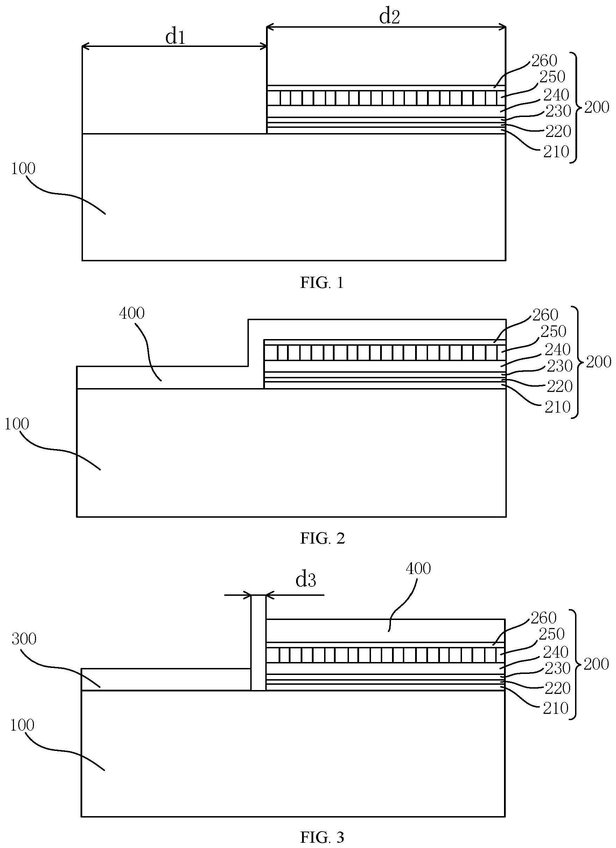

At 1, referring to FIG. 1, the chip-layer group 200 is processed on the substrate 100, and part of the chip-layer group 200 from one side of the substrate 100 to the other side of the substrate 100 is removed to form a waveguide region on the substrate 100.

Specifically, the chip-layer group 200 is processed on the substrate 100 by using a metal organic chemical vapor deposition (MOCVD) device as follows. In sequence, on the substrate 100, an indium phosphide (InP) buffer layer 210 with a thickness of 1µm-1.5µm is grown; an indium aluminum gallium arsenide (InAlGaAs) lower graded-buffer-layer 220 with a thickness of 10nm-100nm is grown; an indium aluminum arsenide (InAlAs)/InAlGaAs quantum-well-layer group 230 with a thickness of 10nm-30nm is grown; an InAlGaAs upper graded-buffer-layer 240 with a thickness of 10nm-100nm is grown; a grating epitaxial layer with a thickness of 10nm-50nm is grown, and a grating is processed by an electron beam grating-writing process to form a grating layer 250; and an indium gallium arsenide phosphide (InGaAsP) corrosion stop layer 260 with a thickness of 10nm-50nm is grown, and preferably, an InGaAsP corrosion stop layer with a thickness of 15nm is processed by an MOCVD process.

As shown in FIG. 1, by a photoetching process, an inductively coupled plasma (ICP) dry etching process, and a wet etching process, part of the chip-layer group 200 is removed to form the waveguide region. In a laser emitting direction, a length of the waveguide region is *d₁,* a length of the chip-layer group 200 is *d₂.* In implementations, *d₁* ranges from 50 µm to 100 µm, and *d₂* ranges from 150 µm to 300 µm.

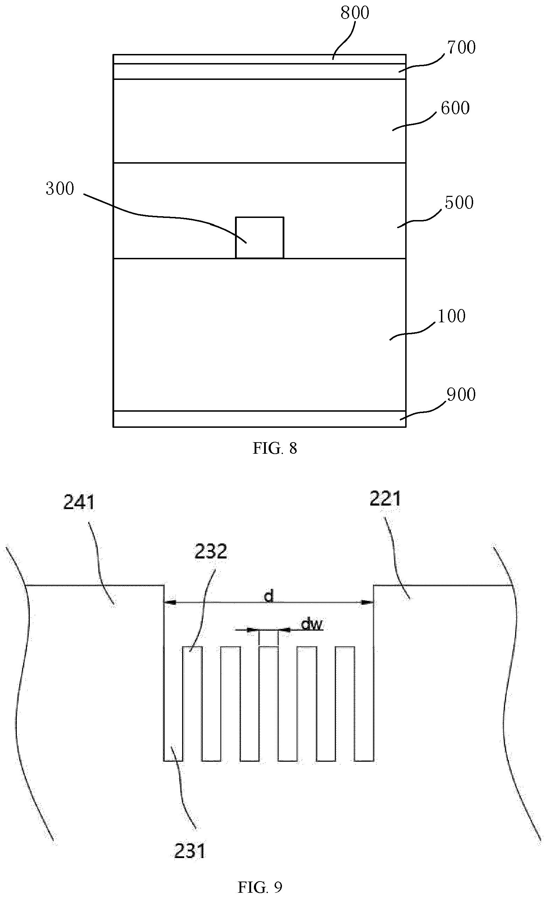

Referring to FIG. 9, a lower-graded-layer group includes a first lower-graded-layer and a second lower-graded-layer 221. The first lower-graded-layer has a thickness of 50 nm, and the second lower-graded-layer 221 has a thickness of 10 nm. The first lower-graded-layer is processed on the InP buffer layer by the MOCVD process, and the second lower-graded-layer 221 is processed on the first lower-graded-layer by a molecular beam epitaxy (MBE) process. The first lower-graded-layer and the second lower-graded-layer each are made of InAlxGaAs.

The second lower-graded-layer with a relatively thin thickness is grown first by the MBE process, so as to prepare for the subsequent MBE growth of the InAlAs quantum well layer and the InAlGaAs quantum well layer, such that it is avoided that when the InAlAs quantum well layer or InAlAs quantum well layer is grown directly, an Al element is oxidized during growth, thereby resulting in a failure of a device.

Multiple quantum well layers are processed by the MBE process, and each quantum well layer has a thickness of 0.4 nm-0.6 nm.

Specifically, an InAlAs quantum well layer 231 with a thickness of 0.5 nm and an InAlGaAs quantum well layer 232 with a thickness of 0.5 nm are alternately grown by the MBE process. Six InAlAs quantum well layers 231 are processed, five InAlGaAs quantum well layers 232 are processed, and one InAlAs quantum well layer 231 is on the outside of the multiple quantum well layers.

An upper-graded-layer group includes a first upper-graded-layer with a thickness of 50 nm and a second upper-graded-layer 241 with a thickness of 10 nm. The second upper-graded-layer 241 is processed on an outer InAlAs quantum well layer 231 by the MBE process, and the first upper-graded-layer is processed on the second upper-graded-layer 241 by the MOCVD process. The first upper-graded-layer and the first lower-graded-layer each are made of InAlxGaAs.

A relatively thin first upper-graded-layer is generated first by the MBE process, so that when transferred from an MBE device to an MOCVD device, oxidation failure of the InAlAs quantum well layer or the InAlGaAs quantum well layer can be avoided.

At 2, referring to FIG. 2, a capping layer 400 is grown at the waveguide region and the chip-layer group 200.

Specifically, with the aid of the MOCVD device, an InP capping layer 400 with a thickness of 0.5 µm-2 µm is processed by a vapor phase epitaxy (VPE) growth.

At 3, referring to FIG. 3, the capping layer 400 at the waveguide region is processed into a waveguide strip 300 with an end surface facing the chip-layer group 200, and part of the waveguide strip 300 attached to the chip-layer group 200 is removed to define a gap between the waveguide strip 300 and the chip-layer group 200.

Specifically, the capping layer 400 at the waveguide region is processed into the waveguide strip 300 with a square cross section by a photoetching process and an ICP dry etching process. An edge length of the cross section of the waveguide strip 300 ranges from 0.5 µm to 2 µm. A refractive index of the waveguide strip 300 is 3.1. The gap between the waveguide strip 300 and the chip-layer group 200 is defined as *d₃,* where *d₃* ranges from 1 µm to 5 µm.

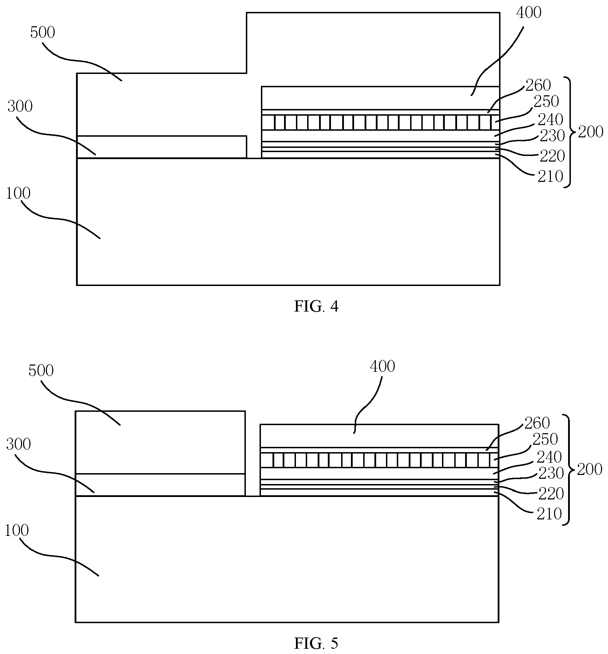

At 4, referring to FIG. 4, a waveguide cladding 500 is processed.

Specifically, a SiO₂ waveguide cladding 500 is deposited by using a plasma-enhanced chemical vapor deposition (PECVD) device, and a deposition thickness ranges from 2 µm to 3 µm. Since the refractive index of the waveguide strip 300 is 3.1 and a refractive index of the SiO₂ waveguide cladding 500 is 1.46, the waveguide strip 300 can be made of an InP material, and the waveguide cladding 500 can be made of SiO₂.

At 5, referring to FIG. 5, the waveguide cladding 500 corresponding to the chip-layer group 200 and the waveguide cladding 500 corresponding to the gap are removed.

Specifically, a waveguide layer at an upper part of the chip-layer group 200 and a waveguide layer at a gap part are removed by the photoetching process and the wet etching process. In implementations, the waveguide layer at a region corresponding to the gap is removed in a vertical laser-emitting direction.

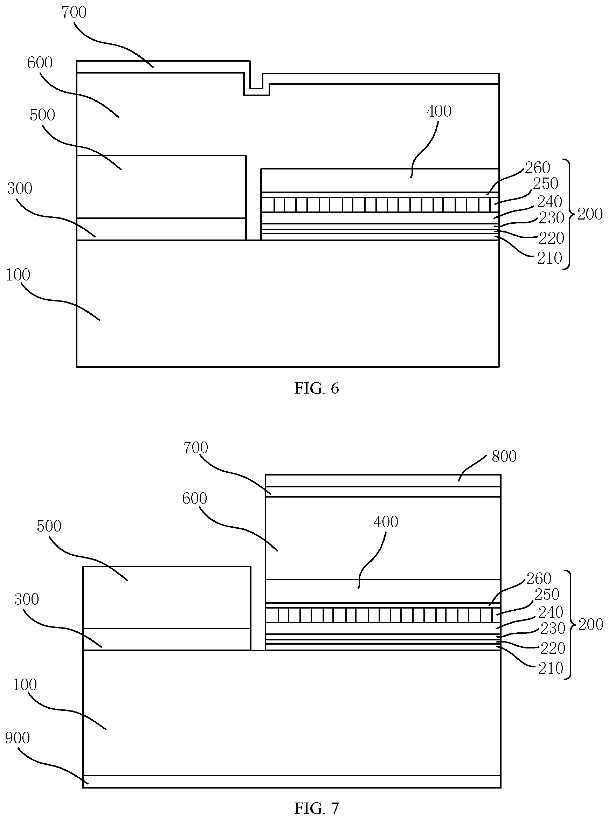

At 6, referring to FIG. 6, after the waveguide cladding 500 is processed, an epitaxial layer 600 and a contact epitaxial layer 700 are processed in sequence.

Specifically, an InP epitaxial layer 600 with a thickness of 1 µm-2 µm is first grown by using the MOCVD device, and then an indium gallium arsenide (InGaAs) contact epitaxial layer 700 with a thickness of 0.1 µm-0.3 µm is grown.

At 7, referring to FIG. 7, the epitaxial layer 600 corresponding to the waveguide region and the contact epitaxial layer 700 corresponding to the waveguide region are removed.

Specifically, the InP epitaxial layer 600 corresponding to the waveguide region and the InGaAs contact epitaxial layer 700 corresponding to the waveguide region are removed by the photoetching process and the wet etching process.

Then, in combination with an existing manufacturing process of a distributed feedback (DFB) laser chip, a backside thinning process and a polishing process are performed on a ridge waveguide, and a coating process is performed on a positive electrode, a negative electrode, a cleavage, and an end surface, so as to form a final DFB laser chip with a waveguide structure. In FIG. 7, an upper negative-electrode layer 800 is processed on the InGaAs contact epitaxial layer 700 corresponding to the chip-layer group 200, and a lower negative-electrode layer 900 is processed on the bottom of the substrate 100.

In implementations, MOCVD is a new type of VPE growth technology developed on the basis of VPE growth. MOCVD means that organic compounds of group III elements and group II elements, hydrides of group V elements and group VI elements, etc., are used as materials of crystal growth source, and VPE is performed on the substrate 100 in a manner of a thermal decomposition reaction, so as to grow a variety of group III-V compound semiconductors and group II-VI compound semiconductors, and thin-layer single-crystal materials of polybasic solid solutions thereof. In represents chemical element indium, P represents chemical element phosphorus, Al represents chemical element aluminum, Ga represents chemical element gallium, As represents chemical element arsenic, the PECVD device is a plasma-enhanced chemical vapor deposition device, and the DFB laser is a distributed feedback laser.

A chip is processed by combining the MOCVD process and the MBE process, and the thickness of a quantum well layer is controlled to ranges from 0.4 nm to 0.6 nm by the MBE process, such that the thickness of a quantum well structure is reduced and the transmission rate of the chip is increased; and in the meanwhile, quantum-well confinement parameter *Γ* is increased, such that the threshold current of the chip is reduced, and the transmission rate of the chip is increased.

A quantum well structure is further provided in implementations. The quantum well structure includes an InAlAs quantum well layer 231 and an InAlGaAs quantum well layer 232. The InAlAs quantum well layer 231 is implemented as multiple InAlAs quantum well layers 231. Thickness of the InAlGaAs quantum well layer 232 is the same as the thickness of the InAlAs quantum well layer 231, and one InAlGaAs quantum well layer 232 is disposed between two adjacent InAlAs quantum well layers 231. The thickness of the InAlAs quantum well layer 231 ranges from 0.4 nm to 0.6 nm, and the number of (that is, how many) InAlAs quantum layers 231 ranges from 3 to 17. Quantum-well confinement parameter *Γ* is expressed by a following formula: *Γ* = (2π²/*λ*²)(d/*dw*)(*nᵣₐ*²*-n_{rc}*²)*,* where *λ* is a lasing wavelength, and *d* is a thickness of an active region, i.e., a thickness of the whole quantum well structure, *dw* is a thickness of a single-layer quantum well. In the solution of implementations, the quantum well structure is formed by alternately stacking quantum well layers of two materials, namely the InAlAs quantum well layer 231 and the InAlGaAs quantum well layer 232. The thickness of the InAlAs quantum well layer 231 is the same as the thickness of the InAlGaAs quantum well layer 232, so *dw* may be the thickness of the InAlAs quantum well layer 231 or the thickness of the InAlGaAs quantum well layer 232, *nᵣₐ* is the refractive index of the InAlGaAs material, and *n_{rc}* is the refractive index of the InAlAs material. For example, the number of InAlAs quantum well layers is 17, the number of InAlGaAs quantum well layers is 16, the thickness of the InAlAs quantum well layer is 0.6, and the value of d is 19.8 nm, and the ratio of *dldw* is 33. According to the formula, it can be seen that under the condition that the value of d is constant, the value of *dldw* can be increased by reducing the thickness of InAlAs quantum well layer and the thickness of the InAlAs quantum well layer, such that quantum-well confinement parameter *Γ* is increased, the threshold current of the chip is reduced, and the transmission rate of the chip is increased.

In the solution, the MOCVD process is combined with the MBE process. The MBE process is adopted to perform epitaxial growth of the quantum well layer, and the MOCVD process is adopted to process various epitaxial growth layers except the quantum well layer. The method for processing the chip includes the following. The buffer layer and the lower-graded-layer group are processed on the substrate in sequence. The multiple quantum well layers are processed by the MBE process. The thickness of each quantum well layer ranges from 0.4 nm to 0.6 nm. The upper-graded-layer group is processed. The capping layer, the corrosion stop layer, a top layer, a transition layer, and a contact layer are processed by the VPE grown. The thickness of the quantum well layer is controlled by the MBE process to range from 0.4 nm to 0.6 nm. Therefore, the thickness of the quantum well structure is reduced, such that the transmission rate of the chip is increased; and in the meanwhile, quantum-well confinement parameter *Γ* is increased, such that the threshold current of the chip is reduced, and the transmission rate of the chip is increased.

Referring to FIG. 9, a quantum well structure is applied to a DFB laser chip. The quantum well structure includes multiple quantum well layers. In the solution of implementations, the quantum well structure includes quantum well layers formed by two materials, namely the InAlAs quantum well layer 231 and the InAlGaAs quantum well layer 232. The InAlAs quantum well layer 231 and the InAlGaAs quantum well layer 232 are alternately arranged, and the InAlAs quantum well layer 231 is on the outside of the quantum well structure.

In the solution, the thicknesses of the InAlAs quantum well layer 231 is the same as the thickness of the InAlGaAs quantum well layer 232. The thickness of the InAlAs quantum well layer 231 ranges from 0.4 nm to 0.6 nm. Preferably, the thickness of the InAlAs quantum well layer 231 and the thickness of the InAlGaAs quantum well layer 232 each are 0.5 nm. The number of the InAlAs quantum well layers 231 ranges from 3 to 17, preferably 6.

The thickness of the quantum well layer is defined as *dw*. Since the thicknesses of InAlAs quantum well layer 231 is the same as the thickness of the InAlGaAs quantum well layer 232, *dw* may be the thickness of InAlAs quantum well layer 231 or the thickness of the InAlGaAs quantum well layer 232. The thickness of the quantum well structure is defined as *d.* When the number of the InAlAs quantum well layers 231 is 6, the number of the InAlGaAs quantum well layers 232 is 5, and the thickness of the InAlAs quantum well layer 231 is 0.5nm, the thickness *d* of the quantum well structure is 5.5 nm. In the InAlGaAs quantum well layer 232, a mass percentage of In is 53%, a mass percentage of Al is 36%, and a mass percentage of Ga and a mass percentage of As sum to 11%.

Quantum-well confinement parameter *Γ* is expressed by a following formula: *Γ* = (2π²/*λ*²)(*d*/*dw*)(*nᵣₐ*²*-n_{rc}*²)*,* where *λ* is a lasing wavelength, *nᵣₐ* is a refractive index of an InAlGaAs material, and *n_{rc}* is a refractive index of an InAlAs material. Under the condition that the thickness of the quantum well structure is constant, when the thickness of the quantum well layer is reduced, a ratio of *d*/*dw* is increased, so a value of *Γ* is increased. With the increase of the quantum-well confinement parameter, the threshold current of the chip is reduced, thereby increasing the transmission rate of the chip.

A chip is further provided in implementations. As shown in FIG. 7 and FIG. 8, the chip includes a substrate 100, a chip-layer group, a waveguide strip 300, and a waveguide cladding 500. The substrate 100 has a chip region and a waveguide region. The chip-layer group is disposed at the chip region of the substrate 100. The waveguide strip 300 is spaced apart from the chip-layer group and integrated at the waveguide region of the substrate 100. The waveguide strip 300 is configured to guide a light spot of laser light emitted to be substantially circular. The waveguide cladding 500 is deposited on the waveguide strip 300. Therefore, a shape of the light spot emitted by the chip is improved, and coupling efficiency between a laser chip and an optical fiber is improved.

The foregoing quantum-well-layer group 230 is adopted in the chip-layer group. The thickness of the InAlAs quantum well layer 231 and the thickness of the InAlGaAs quantum well layer 232 each are small, such that quantum-well confinement parameter *Γ* is increased, the threshold current of the chip is reduced, and the transmission rate is increased.

As shown in FIG. 8, an end surface of the waveguide strip 300 faces the chip-layer group. The gap between the waveguide strip 300 and the chip-layer group ranges from 1 µm to 5 µm. The cross section of the waveguide strip 300 is square, and the edge length of the cross section of the waveguide strip 300 ranges from 0.5 µm to 2 µm. The thickness of the waveguide cladding 500 ranges from 2 µm to 3 µm, and the refractive index of the waveguide strip 300 is greater than the refractive index of the waveguide cladding 500. In implementations, the waveguide cladding 500 is made of SiO₂, and the refractive index of the waveguide cladding 500 is 1.46; and the waveguide strip 300 is made of InP, and the refractive index of the waveguide strip 300 is 3.1.

According to a formula Δ*θ* = 2*λ*/*a*, Δ*θ* is an emitting divergence angle of laser light, *λ* is an emitting wavelength, and *a* is a linewidth of an emitting end surface. Since the cross section of the waveguide strip 300 is square, a light spot of emitted from the waveguide strip 300 is like a circular light spot, thereby improving the coupling efficiency between the laser chip and the optical fiber.

A laser is further provided in implementations. The laser is mounted with the foregoing chip.

The quantum well structure, the method for processing the chip, the chip, and the laser are provided in implementations. The quantum well structure is processed by the MBE process, other epitaxial layers are processed by the MOCVD process except the quantum well structure. The quantum well structure includes quantum well layers formed by two materials, namely, the InAlAs quantum well layer 231 and the InAlGaAs quantum well layer 232. The InAlAs quantum well layer 231 and InAlGaAs quantum well layer 232 are alternately arranged, and the InAlAs quantum well layer 231 is one the outside of the quantum well structure. The thickness of the InAlAs quantum well layer 231 is the same as the thickness of the InAlGaAs quantum well layer 232. The thickness of the InAlAs quantum well layer 231 ranges from 0.4 nm to 0.6 nm. The number of InAlAs quantum well layers 231 ranges from 3 to 17. Quantum-well confinement parameter *Γ* is expressed by the following formula: *Γ* = (2π²/*λ*²)(*d*/*dw*)(*nᵣₐ*²-*n_{rc}*²)*,* where *λ* is the lasing wavelength, *nᵣₐ* is the refractive index of the InAlGaAs material, and *n_{rc}* is the refractive index of the InAlAs material. The thickness of the quantum well layer is reduced by the MBE process, and under the condition that the thickness of the quantum well structure is constant, the ratio of the thickness *d* of the quantum well structure to the thickness *dw* of the single-layer quantum well layer is increased, so the value of *Γ* is increased. With the increase of the quantum-well confinement parameter, the threshold current of the chip is reduced, thereby increasing the transmission rate of the chip.

In the method for processing the chip, the chip-layer group is processed on the substrate, the part of the chip-layer group is removed to form the waveguide region, the capping layer is processed by the growth, the capping layer at the waveguiding region is processed into the waveguide strip with the end surface facing the chip-layer group, and the part of the waveguide strip attached to the chip-layer group is removed to define the gap between the waveguide strip and the chip-layer group. The waveguide strip can shape the laser light emitted by the chip-layer group, so that the light spot of the laser light emitted is like a circle, the shape of the light spot emitted by the laser chip is improved, and the coupling efficiency between the laser chip and the optical fiber is improved. The quantum-well-layer group in the chip-layer group adopts the foregoing quantum well structure.

The laser is mounted with the foregoing chip. The chip may only have the waveguide strip, or only have the foregoing quantum well structure, or simultaneously have the waveguide strip and the foregoing quantum well structure.

It should be noted that relational terms herein such as "first" and "second" are merely used to distinguish one entity or operation from another, and do not necessarily require or imply that any actual relationship or sequence exists between these entities or operations. In addition, the terms "include", "comprise", or any other variant is intended to cover a non-exclusive inclusion, so that a process, a method, an article, or a device that includes a list of elements not only includes those elements but also includes other elements that are not expressly listed, or further includes elements inherent to such a process, method, article, or device. An element preceded by "includes a ..." does not, without more constraints, preclude the presence of additional identical elements in the process, method, article, or device that includes the element.

The foregoing descriptions are merely specific implementations of the present disclosure, so that those skilled in the art can understand or implement the present disclosure. Various modifications to these embodiments will be readily apparent to those skilled in the art, and the general principles defined herein may be implemented in other implementations without departing from the general inventive concept of the present disclosure. Therefore, the present disclosure will not be limited to implementations illustrated herein but is to be accorded the widest scope consistent with the principles and novel features applied herein.

## Claims

1. A quantum well structure for a distributed feedback (DFB) laser chip, comprising:
an indium aluminum arsenide (InAlAs) quantum well layer, wherein the InAlAs quantum well layer is implemented as a plurality of InAlAs quantum well layers; and
an indium aluminum gallium arsenide (InAlGaAs) quantum well layer, wherein a thickness of the InAlGaAs quantum well layer is the same as a thickness of the InAlAs quantum well layer, and the InAlGaAs quantum well layer is disposed between two adjacent InAlAs quantum well layers, wherein
the thickness of the InAlAs quantum well layer ranges from 0.4 nm to 0.6 nm, and the number of the plurality of InAlAs quantum well layers ranges from 3 to 17.

2. The quantum well structure of claim 1, wherein the thickness of the InAlAs quantum well layer is 0.5nm.

3. The quantum well structure of claim 2, wherein the number of the plurality of InAlAs quantum well layers is 6, and the number of InAlGaAs quantum well layers is 5.

4. The quantum well structure of claim 1, wherein in the InAlGaAs quantum well layer, a mass percentage of indium (In) is 53%, a mass percentage of aluminum (Al) is 36%, and a mass percentage of gallium (Ga) and a mass percentage of arsenide (As) sum to 11%.

5. A method for processing a chip, comprising:
processing a buffer layer and a lower-graded-layer group on a substrate in sequence;
processing a plurality of quantum well layers by a molecular beam epitaxy (MBE) process, wherein a thickness of each of the plurality of quantum well layers ranges from 0.4 nm to 0.6 nm;
processing an upper-graded-layer group; and
processing a capping layer, a corrosion stop layer, an epitaxial layer, and a contact epitaxial layer by vapor phase epitaxy (VPE) growth.

6. The method for processing the chip of claim 5, wherein processing the plurality of quantum well layers by the MBE process comprises:
processing 11 quantum well layers by the MBE process.

7. The method for processing the chip of claim 6, wherein the thickness of each of the plurality of quantum well layers is 0.5 nm.

8. The method for processing the chip of claim 5, wherein processing the plurality of quantum well layers by the MBE process comprises:
processing alternately an indium aluminum arsenide (InAlAs) quantum well layer and an indium aluminum gallium arsenide (InAlGaAs) quantum well layer, wherein the InAlAs quantum well layer is on an outside of the plurality of quantum well layers.

9. A chip, processed by the method for processing the chip of any one of claims 5 to 8.

10. A laser, mounted with the chip of claim 9.

11. A method for processing a chip, comprising:
processing a chip-layer group on a substrate;
removing part of the chip-layer group to form a waveguide region;
processing a capping layer by growth;
processing the capping layer at the waveguide region into a waveguide strip with an end surface facing the chip-layer group, and removing part of the waveguide strip attached to the chip-layer group to define a gap between the waveguide strip and the chip-layer group; and
processing a waveguide cladding, and removing the waveguide cladding corresponding to the chip-layer group and the waveguide cladding corresponding to the gap.

12. The method for processing the chip of claim 11, wherein removing the part of the chip-layer group to form the waveguide region comprises:
removing the part of the chip-layer group from one side of the substrate to the other side of the substrate to form the waveguide region.

13. The method for processing the chip of claim 11, wherein processing the capping layer by the growth comprises:
processing the capping layer of 0.5 µm to 2 µm by vapor phase epitaxy (VPE) growth.

14. The method for processing the chip of claim 11, wherein processing the capping layer at the waveguide region into the waveguide strip with the end surface facing the chip-layer group comprises:
processing the capping layer at the waveguide region into the waveguide strip with a square cross section by a photoetching process and a dry etching process, wherein an edge length of the cross section of the waveguide strip ranges from 0.5 µm to 2 µm.

15. The method for processing the chip of claim 11, wherein processing the chip-layer group on the substrate comprises:
processing a buffer layer with a thickness of 1 µm-1.5 µm on the substrate;
processing a lower graded-buffer-layer with a thickness of 10 nm-100 nm;
processing a quantum-well-layer group with a thickness of 10 nm-30 nm;
processing an upper graded-buffer-layer with a thickness of 10 nm-100 nm;
processing a grating epitaxial layer with a thickness of 10 nm-50 nm, and processing a grating by an electron beam grating-writing process; and
processing a corrosion stop layer with a thickness of 10 nm-50 nm in sequence.

16. The method for processing the chip of claim 11, further comprising:
after processing the waveguide cladding,
processing an epitaxial layer and a contact epitaxial layer in sequence, and removing the epitaxial layer at the waveguide region and the contact epitaxial layer at the waveguide region.

17. A chip, comprising:
a substrate having a chip region and a waveguide region;
a chip-layer group disposed at the chip region of the substrate;
a waveguide strip spaced apart from the chip-layer group and integrated at the waveguide region of the substrate, and configured to guide a light spot of laser light emitted to be substantially circular; and
a waveguide cladding deposited on the waveguide strip.

18. The chip of claim 17, wherein a cross section of the waveguide strip is square, and an edge length of the cross section of the waveguide strip ranges from 0.5 µm to 2 µm; and
a thickness of the waveguide cladding ranges from 2 µm to 3 µm, and a refractive index of the waveguide strip is greater than a refractive index of the waveguide cladding.

19. The chip of claim 17, wherein a gap between the waveguide strip and the chip-layer group ranges from 1 µm to 5 µm.

20. A laser, mounted with the chip of any one of claims 17 to 19.
